# EUROPEAN PATENT APPLICATION

(11) **EP 4 797 543 A1**
(43) Date of publication of application: **26.08.2026**
(21) Application number: 24892854.1
(22) Date of filing: 23.07.2024
(51) Int. Cl.: H03M 13/11

(54) **DECODING METHOD FOR LOW-DENSITY PARITY-CHECK CODE, AND ELECTRONIC DEVICE AND STORAGE MEDIUM**

(30) Priority: 21.11.2023 CN 202311563132
(71) Applicant: Honor Device Co., Ltd., Shenzhen, Guangdong 518040 (CN)
(72) Inventor: ZHONG, Haijing, Shenzhen, Guangdong 518040 (CN); PANG, Gaokun, Shenzhen, Guangdong 518040 (CN)
(74) Representative: Henselmann, Alexander Gerhard
(86) International application number: PCT/CN2024/106962
(87) International publication number: WO 2025/107690

(57) **Abstract**

This application relates to the field of communication technologies, and provides a decoding method for a low-density parity-check code, an electronic device, and a storage medium. The method includes: obtaining a processor model of a user terminal, and matching system computing capability information corresponding to the processor model; obtaining a first use case decoding time corresponding to a low-density parity-check LDPC decoding test case; obtaining a maximum number of iterations based on the system computing capability information and the first use case decoding time; and performing LDPC decoding based on the maximum number of iterations when to-be-decoded data is received. In this application, with reference to two aspects including the system computing capability information and the use case decoding time, the maximum number of iterations is cooperatively determined, to perform the LDPC decoding through the maximum number of iterations. This reduces a bit error rate of the LDPC decoding to some extent while meeting a requirement of the communication system for the communication performance, thereby reducing a number of data retransmissions.

## Description

The present invention claims priority to Chinese Patent Application 202311563132.0, filed with the China National Intellectual Property Administration on November 21, 2023 and entitled "DECODING METHOD FOR LOW-DENSITY PARITY-CHECK CODE, ELECTRONIC DEVICE, AND STORAGE MEDIUM".

### TECHNICAL FIELD

This application relates to the field of communication technologies, and in particular, to a decoding method for a low-density parity-check code, an electronic device, and a storage medium.

### BACKGROUND

In a communication system, due to the existence of interferences such as noise, fading and multipath in a transmission channel, distortion and signal decision errors are inevitably introduced into transmitted data. The channel coding technology adds redundant symbols to an information sequence to detect and correct signal errors occurring during transmission, thereby improving reliability of the system. A low-density parity-check (Low-Density Parity-Check, LDPC) code is a class of channel coding and decoding codes with excellent performance that can approach the Shannon limit, which has been standardized in 5G systems at present and even continues to be used and optimized in future 6G systems.

A common LDPC decoding algorithm may be classified as a message passing algorithm, which is essentially an iterative algorithm. In the LDPC decoding algorithm, a maximum number of iterations directly affects decoding performance. Under the same channel condition, a larger numerical value set for the maximum number of iterations indicates a lower decoding bit error rate of the LDPC decoding algorithm, and then leads to a smaller number of data retransmissions. However, the communication system has strict requirements on slot processing of a sending terminal and a receiving terminal. A larger number of iterations actually used in the LDPC decoding indicates more time occupied by the LDPC decoding. This may reduce a data throughput rate, and even result in loss of communication synchronization due to the failure of the communication system to complete decoding in a timely manner.

### SUMMARY

This application provides a decoding method for a low-density parity-check code, an electronic device, and a storage medium, which can reduce a bit error rate of LDPC decoding to some extent while meeting a requirement of a communication system on communication performance.

To achieve the foregoing objective, this application adopts the following technical solutions.

According to a first aspect, this application provides a decoding method for a low-density parity-check code, including: obtaining a processor model of a user terminal, and matching system computing capability information corresponding to the processor model; obtaining a first use case decoding time corresponding to a low-density parity-check LDPC decoding test case; obtaining a maximum number of iterations based on the system computing capability information and the first use case decoding time; and performing LDPC decoding based on the maximum number of iterations when to-be-decoded data is received. For the system computing capability information, higher system computing capability information of a user terminal indicates a faster speed for performing one iteration of LDPC decoding. On the premise of ensuring communication performance, the user terminal having higher system computing capability information can match a larger maximum number of iterations. For a use case decoding time, a shorter use case decoding time indicates a faster LDPC decoding speed. On the premise of meeting a requirement of the communication system for communication performance, a user terminal spending a shorter use case decoding time can match a larger maximum number of iterations. With reference to two aspects including the system computing capability information and the first use case decoding time, the maximum number of iterations is cooperatively matched, thereby reducing the bit error rate of the LDPC decoding to some extent when the user terminal meets the requirement for communication performance, and reducing the number of data retransmissions.

In a possible implementation, a plurality of LDPC decoding test cases are provided, decoding times respectively corresponding to the plurality of LDPC decoding test cases are obtained, and the first use case decoding time is obtained based on the plurality of decoding times. A time for the user terminal to perform LDPC decoding in different scenarios can be obtained through the plurality of LDPC decoding test cases, so that the obtained use case decoding time can be closer to an actual situation.

In a possible implementation, the maximum number of iterations corresponding to the system computing capability information and the first use case decoding time is obtained based on a matching table of iterations. A preset matching table of iterations is used to match the corresponding maximum number of iterations of LDPC decoding, so that a matching process of the maximum number of iterations can be simplified. In addition, for different user terminals, a unified matching table of iterations can be used to match the corresponding maximum number of iterations through a unified matching rule.

In a possible implementation, a first number of iterations corresponding to the system computing capability information is matched based on the matching table of iterations, a second number of iterations corresponding to the decoding time is matched based on the matching table of iterations, and the maximum number of iterations corresponding to the system computing capability information and the first use case decoding time is determined based on the first number of iterations and the second number of iterations. Corresponding numbers of iterations are respectively matched based on the system computing capability information and the use case decoding time, and a smaller number of iterations among the two numbers of iterations is selected as the maximum number of iterations, ensuring that the selected maximum number of iterations meets both the system computing capability information and the use case decoding time.

In a possible implementation, a set of maximum numbers of iterations corresponding to the system computing capability information is screened out from the matching table of iterations. The maximum number of iterations corresponding to the decoding time is screened out from the set of maximum numbers of iterations, or the set of maximum numbers of iterations corresponding to the first use case decoding time is screened out from the matching table of iterations. The maximum number of iterations corresponding to the system computing capability information is screened out from the set of maximum numbers of iterations. The set of maximum numbers of iterations is determined based on the system computing capability information or the use case decoding time, and then the maximum number of iterations is determined from the set of maximum numbers of iterations based on the use case decoding time or the system computing capability information, ensuring that the selected maximum number of iterations meets both the system computing capability information and the use case decoding time.

In a possible implementation, the system computing capability information and the first use case decoding time are sent to a network side device, so that the network side device determines the maximum number of iterations based on the system computing capability information and the first use case decoding time, and returns the maximum number of iterations. The corresponding system computing capability information and the first use case decoding time are sent to the network side device, and the network side device matches the maximum number of iterations based on the system computing capability information and the first use case decoding time, and sends the maximum number of iterations to the user terminal, thereby reducing occupation of computing resources of a user equipment.

In a possible implementation, when the to-be-decoded data is received, the LDPC iterative decoding starts to be performed based on the maximum number of iterations. When the number of iterations reaches the maximum number of iterations, or a decoding result of the LDPC iterative decoding passes a check, the LDPC iterative decoding is terminated. An iteration stop condition is improved as follows: when the number of iterations reaches the maximum number of iterations matched based on the system computing capability information and the first use case decoding time, or the decoding result of the LDPC iterative decoding passes a check. A fixed maximum number of iterations is no longer used as the iteration stop condition.

In a possible implementation, when the LDPC iterative decoding starts to be performed, a timer starts timing. A detection as to whether the timer times out is performed during the LDPC iterative decoding. The maximum number of iterations is adjusted when the timer times out, and the LDPC iterative decoding is performed based on the adjusted maximum iterative decoding. A detection as to whether a system load of the user terminal increases is performed through the timer. If the system load increases, the LDPC iterative decoding time increases. This may affect communication performance, and the maximum number of iterations is readjusted to ensure communication performance.

In a possible implementation, a second use case decoding time corresponding to the LDPC decoding test case is obtained. The maximum number of iterations is re-obtained based on the system computing capability information and the second use case decoding time. The maximum number of iterations is adjusted to the re-obtained maximum number of iterations. When the timer times out, the LDPC decoding test case is rerun, and the second use case decoding time is re-obtained, thereby rematching the corresponding maximum number of iterations based on the second use case decoding time, and ensuring that the rematched maximum number of iterations can also ensure communication performance when the system load of the user terminal increases.

In a possible implementation, the timer is cleared when the timer has not timed out and the LDPC iterative decoding is not terminated. When the timer has not timed out and the LDPC iterative decoding is terminated, the timer is cleared, so that timing is performed again during next LDPC iterative decoding.

In a possible implementation, the method is applied to a first user terminal. A second user terminal receives and forwards the to-be-decoded data to the first user terminal. The first user terminal performs the LDPC iterative decoding on the to-be-decoded data based on the maximum number of iterations, to obtain the decoding result of the LDPC iterative decoding, and returns the decoding result of the LDPC iterative decoding to the second user terminal. For a scenario of cooperative decoding, when receiving a to-be-decoded data packet, another user terminal sends the to-be-decoded data packet to the user terminal. The user terminal performs LDPC iterative decoding on the to-be-decoded data packet based on the matched maximum number of iterations, to obtain an LDPC decoding result, and feeds back the LDPC decoding result to the another user terminal, thereby implementing cooperative decoding between the user terminal and the another user terminal. In addition, the system computing capability information of the another user terminal is poorer than the system computing capability information of the user terminal, and performance of LDPC decoding of the another user terminal is improved.

In a possible implementation, the processor model of the user terminal is obtained in response to an initialization operation of the user terminal. In response to the initialization operation of the user terminal, the processor model of the user terminal is obtained. Therefore, a match of the maximum number of iterations does not need to be performed for each LDPC iterative decoding, thereby reducing repeated waste of computing resources of the user terminal.

According to a second aspect, this application provides an electronic device. The electronic device includes a processor and a memory. The memory stores computer-executable instructions. The processor executes the computer-executable instructions stored in the memory, to enable the processor to perform the foregoing method according to the first aspect.

According to a third aspect, this application provides a computer-readable storage medium. The computer-readable storage medium stores a computer program or instructions. The computer program or the instructions, when run, implement the foregoing method according to the first aspect.

According to a fourth aspect, this application provides a computer program product, including a computer program or instructions. The computer program or the instructions, when executed by a processor, implement the foregoing method according to the first aspect.

### BRIEF DESCRIPTION OF DRAWINGS

FIG. 1 is a schematic flowchart of a decoding method for a low-density parity-check code according to an embodiment of this application;
FIG. 2 is a schematic flowchart of a manner of matching system computing capability information according to an embodiment of this application;
FIG. 3 is a schematic flowchart of another decoding method for a low-density parity-check code according to an embodiment of this application;
FIG. 4 is a schematic flowchart of another decoding method for a low-density parity-check code according to an embodiment of this application;
FIG. 5 is a schematic flowchart of another decoding method for a low-density parity-check code according to an embodiment of this application; and
FIG. 6 is an example composition diagram of an electronic device according to an embodiment of this application.

### DESCRIPTION OF EMBODIMENTS

Terms "first", "second", "third", and the like in the specification, claims, and accompanying drawings of this application are used to distinguish between different objects rather than to limit a specific order.

In embodiments of this application, a phrase such as "in an example" or "for example" is used to represent giving an example, an illustration, or a description. Any embodiment or design solution described as "in an example" or "for example" in embodiments of this application should not be explained as being more preferred or advantageous than another embodiment or design scheme. Exactly, use of the phrase such as "in an example" or "for example" is intended to present a related concept in a specific manner.

The advantages of the decoding method for a low-density parity-check code provided in this application are described based on the principle of LDPC decoding.

In an LDPC iterative decoding algorithm, a maximum number of iterations directly affects decoding performance. Under a same channel condition, a larger numerical value set for the maximum number of iterations indicates a lower decoding bit error rate of the LDPC decoding algorithm, and leads to a smaller number of data retransmissions. However, the communication system has strict requirements on slot processing of a sending terminal and a receiving terminal. A larger number of iterations actually used in the LDPC decoding may also be understood that a larger numerical value set for the maximum number of iterations indicates more time occupied by the LDPC decoding. This may reduce a data throughput rate, and even result in loss of communication synchronization due to the failure of the communication system to complete decoding in a timely manner.

In addition, if the channel quality is moderate and the numerical value set for the maximum number of iterations is relatively small, the time occupied by LDPC decoding may be reduced, thereby ensuring the communication performance. However, the relatively small numerical value of the maximum number of iterations may lead to a failure to complete the LDPC decoding correctly or a relatively high bit error rate of the LDPC decoding, and result in an increase in the number of data retransmissions. If the channel quality is excessively poor and data errors received by the user terminal exceed capabilities of LDPC decoding, the LDPC iterative decoding cannot be completed correctly regardless of the number of iterations performed. Therefore, even if the maximum number of iterations is set to an excessively large numerical value, the data throughput may not be necessarily reduced.

This application provides a decoding method for a low-density parity-check code. A maximum number of iterations of LDPC decoding is obtained based on system computing capability of a user terminal and an LDPC decoding test case, so that the maximum number of iterations of the LDPC decoding can be adaptively adjusted based on computing capability of hardware of the user terminal. To be specific, the maximum number of iterations of the LDPC decoding is cooperatively determined based on two aspects including system computing capability information and a use case decoding time. The adaptively adjusted maximum number of iterations is the number of iterations with the maximum numerical value that can be set while ensuring communication performance, thereby reducing a bit error rate of the LDPC decoding to some extent while meeting a requirement of a communication system for communication performance, and reducing a number of data retransmissions.

The decoding method for a low-density parity-check code provided in this application may be applicable to communication between user terminals, communication between a user terminal and a network side device, and the like. The decoding method for a low-density parity-check code is basically applicable to all communication systems such as a wireless communication system. For example, the user terminal may decode a to-be-decoded data packet transmitted by another user terminal, or may decode the to-be-decoded data packet transmitted by the network side device. The wireless communication system includes: a global system for mobile communications (global system for mobile communications, GSM), a 5G mobile communication system, a general packet radio service (general packet radio service, GPRS), a global navigation satellite system (global navigation satellite system, GLONASS), a Beidou navigation satellite system (beidou navigation satellite system, BDS), and the like.

The decoding method for a low-density parity-check code provided in this application may be independently completed by the user terminal, may be completed through cooperation between the user terminal and the network side device, and may further be cooperatively completed by a plurality of user terminals. The three completion manners are respectively described below through three embodiments.

### Embodiment I:

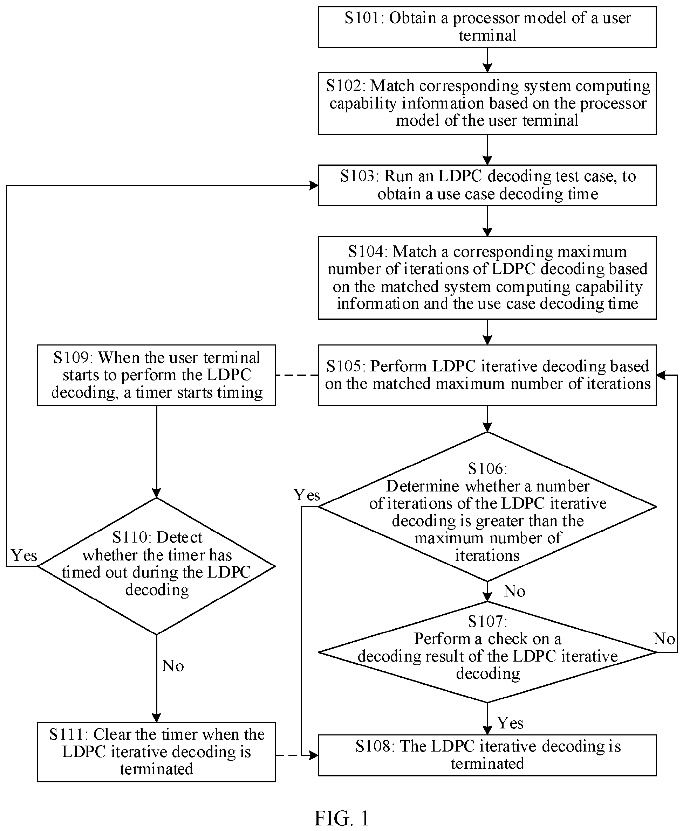

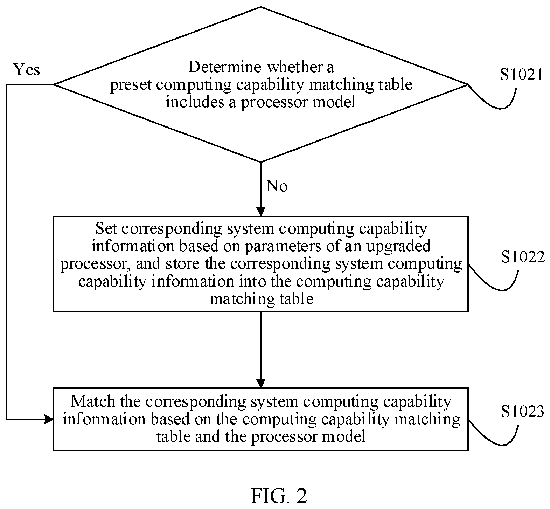

A decoding method for a low-density parity-check code provided in this embodiment of this application is described in detail below with reference to FIG. 1 and FIG. 2. The method is performed by a user terminal. In other words, a decoding method for a low-density parity-check code provided in embodiments of this application is independently performed by the user terminal. The method includes the following steps.

S101: A user terminal obtains a processor model of the user terminal.

The user terminal (User Equipment, UE) may be a mobile phone, a tablet computer, a desktop computer, a laptop computer, a notebook computer, an ultra-mobile personal computer (Ultra-mobile Personal Computer, UMPC), a handheld computer, a netbook, a personal digital assistant (Personal Digital Assistant, PDA), a wearable electronic device, a smart watch, or the like. This application does not impose any special restrictions on a specific form of the user terminal.

It should be noted that the user terminal may also be referred to as an electronic device. This is not specifically limited in this application.

Specifically, the processor model of the user terminal is obtained in response to an initialization operation of the user terminal.

It may be understood that after a system program of the user terminal is run (that is, after the user terminal is initialized and the user terminal is powered on and started), the user terminal obtains the processor model by using a software command. When the user terminal includes only one processor, a model of the processor is obtained through the software command. When the user terminal includes a plurality of processors, the user terminal obtains models of the plurality of processors by using a software command. For example, when the user terminal includes a main processor and a coprocessor, the user terminal obtains models of the main processor and the coprocessor by using software instructions.

In a possible implementation, the processor of the user terminal may execute cross-compiled code. In a cross-compilation scenario where the user terminal is a user terminal that executes the cross-compiled code, the user terminal still obtains the processor model thereof (i.e., the model of the processor that executes the cross-compiled code), rather than the processor model for compiling the source code.

Compilation (Compile) is a process of converting source code into machine code. Source code cannot be executed by a machine (i.e., a processor), only after being converted into binary machine code can it be executed by a machine (i.e., a processor).

Cross-compilation refers to a scenario where the platform for compiling source code and a platform for executing a program generated by compiling the source code are two different platforms.

For example, a cross-compilation scenario may involve performing cross-compilation on the source code on a platform with relatively high computing capability. After the cross-compilation is successfully completed, the compiled program is flashed onto an ARM development board with relatively low computing capability. In this case, computing capability of a processor (CPU) that compiles the source code is stronger than computing capability of the processor (CPU) that executes the compiled code.

Since the LDPC decoding is performed by the user terminal to which the processor running the cross-compiled code belongs, the model of the processor running the cross-compiled code is obtained, and the system computing capability system computing capability information of the processor running the cross-compiled code is matched, thereby matching the maximum number of iterations corresponding to the model of the processor running the cross-compiled code.

S102: The user terminal matches corresponding system computing capability information based on the processor model of the user terminal.

Specifically, the corresponding system computing capability information is matched based on a preset computing capability matching table and the processor model of the user terminal.

The system computing capability information may represent system computing capability of the user terminal.

In a possible implementation, the system computing capability information is preset through parameters of the processor. The parameters of the processor include a clock speed, a maximum boost frequency, a cache, a number of cores, and the like.

The clock speed is a clock frequency of a processor core, and may be directly understood as a processing/operation speed of the processor. Generally, a higher clock speed of the processor indicates a faster processing speed of the processor and better performance of the processor.

The maximum boost frequency is a highest frequency that can be reached by a boost frequency acceleration technology of the processor. The boost frequency acceleration technology may perform flexible adjustment based on strength of a task of the processor. For example, when a processor temperature is excessively high, the frequency is automatically reduced to avoid burnout due to overheating, and when the workload is heavy, the frequency is appropriately increased for quick completion.

The cache is used to address the problem of an excessive gap between the processing speed of the processor and the memory access speed. Specifically, when the processing speed of the processor is extremely fast and read/write tasks of a memory module cannot match, the processor can store the relevant data in the cache, thereby alleviating the mismatch between the processing speed of the processor and the memory read/write speed (i.e., the access speed).

The number of cores is a number of cores of the processor, that is, a number of core chips on the processor, for example, a dual-core processor, a quad-core processor, a hexa-core processor, and an octa-core processor. The dual-core processor indicates that the processor includes 2 relatively independent core chips, and the quad-core processor indicates that the processor includes 4 relatively independent core chips.

In a possible implementation, the system computing capability information is represented through a numerical value. A larger numerical value indicates stronger system computing capability of the user terminal.

It should be noted that the system computing capability information may be set/assigned for the system computing capability information of the processor model by a developer based on a processor model and a corresponding processor parameter, or the corresponding system computing capability information may be comprehensively calculated through a specific calculation formula. This is not specifically limited in this application.

For ease of understanding, the corresponding system computing capability information to be matched is described through examples below based on Table 1. The system computing capability information is represented through a numerical value.

**Table 1**

| Processor model | System computing capability information |
|---|---|
| Intel Core i9-13900, A100 | 100 |
| Intel Core i7-13700, RTX4090 | 90 |
| Intel Core i5-13600K, RTX4070 | 80 |
| Intel Core i9-12900, GT7300 | 70 |
| Intel Core i5-12600 | 60 |
| Intel Core i5-10400 | 50 |
| Intel Core i3-10100 | 40 |

In the computing capability matching table shown in Table 1, when the processor model is Intel Core i9-13900 and A100 (that is, the main processor and the coprocessor), corresponding system computing capability information to be matched is 100. When the processor model is Intel Core i7-13700 and RTX4090, corresponding system computing capability information to be matched is 90. When the processor model is Intel Core i5-12600 (that is, the main processor), corresponding system computing capability information to be matched is 60, and so on.

In a possible implementation, specific implementation steps of S102 are shown in FIG. 2. The specific implementation steps of S102 shown in FIG. 2 are mainly applied to a scenario after hardware components such as a processor and a memory of the user terminal are upgraded.

S1021: The user terminal determines whether the preset computing capability matching table includes the processor model.

The processor model of the user terminal may not exist in the preset computing capability matching table. Therefore, it needs to be determined whether the computing capability matching table includes the processor model. For example, after the hardware components such as the processor and the memory of the user terminal are upgraded, a model of the processor of the current user terminal has actually changed with the upgrade. However, since the hardware components such as the processor and the memory of the user terminal are upgraded, an upgraded processor model may not exist in the preset computing capability matching table. Therefore, it needs to be determined whether the model of the upgraded processor is included.

It should be noted that the upgrade of hardware by the user terminal needs to be performed when the user terminal is not started (when the user terminal has not started to run a program or has not started initialization). After the upgrade of the hardware components of the user terminal is completed, the user terminal starts to run the program (that is, startup or initialization is started), and a model of an upgraded server of the user terminal is obtained.

When it is determined that the preset computing capability matching table includes the processor model, S1023 is directly performed.

When it is determined that the preset computing capability matching table does not include the processor model, S1022 is performed.

S1022: The user terminal sets corresponding system computing capability information based on parameters of the upgraded processor, and stores the system computing capability information into the computing capability matching table.

In a possible implementation, the system computing capability information is calculated through a preset formula based on parameters (for example, a main frequency, a maximum boost frequency, a cache, and a number of cores) of the processor of the user terminal, and the processor model and the system computing capability information are correspondingly stored into the computing capability matching table.

For example, the system computing capability information is calculated through preset formula based on the parameters of the upgraded processor, and the upgraded processor model and the system computing capability information are correspondingly stored into the computing capability matching table.

It should be noted that after the hardware components such as the processor and the memory of the user terminal are upgraded, the model of the processor of the current user terminal has changed with the upgrade. Therefore, the model of the upgraded processor can be stored in the computing capability matching table.

S1023: Corresponding system computing capability information is matched based on the computing capability matching table and the processor model.

S103: The user terminal runs an LDPC decoding test case, to obtain a use case decoding time.

Specifically, the running an LDPC decoding test case may be understood as that the user terminal decodes an LDPC code of the LDPC decoding test case until the LDPC decoding is terminated. That the decoding of the LDPC decoding test case is terminated generally means that LDPC iterative decoding is terminated after it is determined that the decoding is correct.

For example, the LDPC decoding test case may be an LDPC code with added noise using a specific noise addition algorithm, and a corresponding fixed parity-check matrix. That the user terminal runs the LDPC decoding test case is actually that the user terminal decodes the LDPC code with added noise based on the fixed parity-check matrix until the LDPC decoding is terminated. It should be noted that for different LDPC decoding test cases, code lengths and code rates of LDPC codes may vary. The code rate refers to a ratio of useful information to all information in an encoded data stream. The LDPC code rate is a ratio of an information length of the LDPC code to an LDPC code length.

In a possible implementation, a plurality of LDPC decoding test cases are provided. The plurality of LDPC decoding test cases may be a plurality of LDPC codes obtained based on different generated parity-check matrices.

When the plurality of LDPC decoding test cases are provided, in a possible implementation, a use case decoding time may be an average value of decoding times consumed for running the plurality of LDPC decoding test cases. For example, 5 LDPC decoding test cases are provided, which are respectively an LDPC decoding test case A, an LDPC decoding test case B, an LDPC decoding test case C, an LDPC decoding test case D, and an LDPC decoding test case E, corresponding decoding times consumed for running the LDPC decoding test cases are respectively ta, tb, tc, td, and te, and the use case decoding time is (ta+tb+tc+td+te)/5. In another possible implementation, different weights may be allocated to the decoding times consumed by the plurality of LDPC decoding test cases, and decoding test times consumed are calculated based on the weights.

The use case decoding times corresponding to the plurality of LDPC decoding test cases are obtained through the plurality of LDPC decoding test cases, that is, times consumed by the user terminal to perform LDPC decoding in a plurality of scenarios are obtained, so that the finally obtained corresponding use case decoding time is closer to an actual situation, thereby avoiding uniqueness and burstiness of obtaining the corresponding use case decoding time only through one LDPC decoding test case. For example, the user terminal may decode a specific LDPC code very quickly, but decode another LDPC code relatively slowly.

S104: The user terminal matches the corresponding maximum number of iterations of the LDPC decoding based on the matched system computing capability information and the use case decoding time.

Specifically, the corresponding maximum number of iterations of the LDPC decoding is matched based on a preset matching table of iterations and the matched system computing capability information and the use case decoding time.

For the system computing capability information, higher system computing capability information of the user terminal indicates a faster speed for performing one iteration of LDPC decoding. In other words, for a same LDPC code, higher system computing capability information indicates a faster LDPC decoding speed, that is, a shorter time occupied for performing the LDPC decoding. On the premise of ensuring communication performance (meeting a strict requirement for slot processing of a sending terminal and a receiving terminal in a communication system), the user terminal having higher system computing capability information can match a larger maximum number of iterations.

For a use case decoding time, a shorter use case decoding time indicates a faster LDPC decoding speed. On the premise of meeting a requirement for communication performance (meeting a strict requirement for slot processing of the sending terminal and the receiving terminal in the communication system), the user terminal spending a shorter use case decoding time can match a larger maximum number of iterations.

In this embodiment of this application, with reference to two aspects including the system computing capability information and the use case decoding time, the maximum number of iterations is cooperatively matched, thereby implementing matching of the maximum number of iterations with the maximum numerical value by the user terminal while ensuring communication performance.

In a possible implementation, the corresponding number of iterations with the maximum numerical value is matched based on the system computing capability information and the use case decoding time respectively, to determine a smaller one of the two numbers of iterations with the maximum numerical value as the maximum number of iterations of the user terminal. For example, the number of iterations with the maximum numerical value matched based on the system computing capability information is a first number of iterations, the number of iterations with the maximum numerical value matched based on the use case decoding time is a second number of iterations, and the first number of iterations is greater than the second number of iterations. Therefore, the maximum number of iterations matched by the user terminal is the second number of iterations.

In a possible implementation, a set of maximum numbers of iterations may be first determined based on the matched system computing capability information and the preset matching table of iterations, and then the corresponding maximum number of iterations of the LDPC decoding is matched from the set of maximum numbers of iterations based on the use case decoding time and the preset matching table of iterations.

In another possible implementation, the set of maximum numbers of iterations may be first determined based on the use case decoding time and the preset matching table of iterations, and then the corresponding maximum number of iterations of the LDPC decoding is matched from the set of maximum numbers of iterations based on the matched system computing capability information and the preset matching table of iterations.

For ease of understanding, the corresponding maximum number of iterations of the LDPC decoding to be matched is described through examples below based on Table 2.

**Table 2**

| Use case decoding time | System computing capability information | Maximum number of iterations |
|---|---|---|
| < 20 us | > 90 | 15 |
| < 30 us | > 80 | 13 |
| < 40 us | > 70 | 10 |
| < 50 us | > 60 | 5 |
| < 60 us | > 50 | 3 |
| < 70 us | > 40 | 2 |

Based on the matching table of iterations shown in Table 2, when the use case decoding time of the user terminal is 15 us, and the matched system computing capability information is 81, it is determined, based on the use case decoding time being 15 us, that the maximum number of iterations with the maximum numerical value is 15. It is determined, based on the system computing capability information being 81, that the maximum number of iterations with the maximum numerical value is 13, and then it is determined that the maximum number of iterations is 13.

Based on the matching table of iterations shown in Table 2, when the use case decoding time of the user terminal is 35 us, and the matched system computing capability information is 83, it may be first determined, based on the use case decoding time 35 us, that the set of maximum numbers of iterations is {10, 5, 3, 2}. The corresponding maximum number of iterations of 10 is matched from the set of maximum numbers of iterations based on the system computing capability information 83.

Based on the matching table of iterations shown in Table 2, when the use case decoding time of the user terminal is 21 us, and the matched system computing capability information is 69, the set of maximum numbers of iterations may be first determined as {5, 3, 2} based on the system computing capability information 69. The corresponding maximum number of iterations of 5 is matched from the set of maximum numbers of iterations based on the use case decoding time 21 us.

It should be noted that the preset matching table of iterations may be set by a developer based on historical practical engineering values of user terminals corresponding to various processor models, and adjusted through a simulation experiment. This is not specifically limited in this application.

S105: The user terminal performs the LDPC iterative decoding based on the matched maximum number of iterations.

After receiving to-be-decoded data, the user terminal performs equalization and demodulation on received data, and then performs the LDPC iterative decoding based on the matched maximum number of iterations.

S106: The user terminal determines whether a number of iterations of the LDPC iterative decoding is greater than the maximum number of iterations.

When the number of iterations of the LDPC iterative decoding is not greater than the maximum number of iterations, S107 is performed.

When the number of iterations of the LDPC iterative decoding is greater than the maximum number of iterations, S108 is performed.

S107: The user terminal performs a check on a decoding result of the LDPC iterative decoding.

In a possible implementation, a cyclic redundancy check is performed on the decoding result of the LDPC iterative decoding.

A cyclic redundancy check (Cyclic Redundancy Check, CRC) is a data transmission error detection function. Polynomial calculation is performed on data, and an obtained result is appended to a frame. A receiving device also executes a similar algorithm, to ensure correctness and integrity of data transmission.

When the decoding result of the LDPC iterative decoding passes the check, S108 is performed.

When the decoding result of the LDPC iterative decoding does not pass the check, S105 is performed, that is, the LDPC iterative decoding continues to be performed, and then it is determined whether the number of iterations of the LDPC iterative decoding is greater than the maximum number of iterations and whether the decoding result passes the check. The LDPC iterative decoding is terminated until the number of iterations of the LDPC iterative decoding is greater than the maximum number of iterations (reaching the maximum number of iterations) or the decoding result of the LDPC iterative decoding passes the check.

S108: The LDPC iterative decoding is terminated.

A corresponding LDPC decoding result is outputted after the end of the LDPC iterative decoding.

It should be noted that in current technologies, a method for adjusting the maximum number of iterations of LDPC decoding is provided. For example, one existing technology is to perform channel estimation on a wireless channel, and adjust a maximum number of iterations of LDPC decoding for a next data transmission based on a channel estimation result, and the other existing technology is to dynamically adjust a current number of iterations based on a historical number of iterations and the maximum number of iterations. In the method for adjusting the maximum number of iterations of LDPC decoding in the current technologies, each execution of the LDPC iterative decoding is followed by a corresponding adjustment of the LDPC iterative decoding. This results in repeated waste of computing resources of the user terminal. However, in S101 to S104 in embodiments of this application, a process of matching the maximum number of iterations of the user terminal only needs to be performed when the user terminal is initialized (when powered on and started), thereby saving computing resources of the user terminal.

In a possible implementation, with the operation of the user terminal, a system load of a processor of the user terminal may increase due to a specific reason. Due to the increase in the system load, a time for which the user terminal performs the LDPC iterative decoding may increase. This may affect performance of the communication system. For the foregoing conditions, it may be determined through a timer whether the system load of the processor of the user terminal increases. When the system load increases, the maximum number of iterations of the LDPC decoding of the user terminal needs to be adjusted.

An excessively high system load may prevent the processor from processing another request and operation, and even cause a crash. The system load is a measure of current workload of the processor, and is defined as an average number of threads in a running queue within a specific time interval. A load average (load average) represents a load average of the processor within a period of time, that is, represents a system load of the current processor, and the value is as small as possible.

Specific reasons causing the increase in the system load include an increased temperature of the processor, hardware damage of the processor, an attack on the processor, and the like.

For ease of understanding, a detailed description is provided below with reference to S109 to S111 shown in FIG. 1. The user terminal also performs S109-S111 simultaneously when performing S105-S108.

S109: When the user terminal starts to perform the LDPC decoding, a timer starts timing.

The timer in the user terminal is task timing reminder software. The timer can execute a corresponding task after a preset time is reached, and is one of the most commonly used modules in the user terminal. In this application, the timer of the user terminal is a timer corresponding to an LDPC decoding task.

The preset time of the timer is related to a matched maximum number of iterations of the user terminal. A sub-preset time is configured for one iteration of the LDPC iteration in advance based on a test/simulation result of the LDPC iterative decoding, and the preset time of the timer is obtained based on the matched maximum number of iterations of the user terminal and the sub-preset time. The preset time may be used to represent an estimated value of a time consumed by the user terminal to perform the LDPC decoding of the maximum number of iterations, and the preset time is slightly greater than an actual time consumed by the user terminal to perform the LDPC decoding of the maximum number of iterations.

S110: During the LDPC decoding, the user terminal detects whether the timer times out.

During the LDPC decoding, that is, before the LDPC decoding is terminated, a detection as to whether the timer times out is performed.

When it is detected that the timer times out, the maximum number of iterations of the LDPC decoding is adjusted according to a preset rule, and S103 and S104 are performed again.

When it is detected that the timer times out, it indicates that the system load of the processor of the user terminal greatly increases, and a speed at which the user terminal performs the LDPC decoding has been affected. This may affect current communication performance, that is, the requirements of the communication system for slots of the sending terminal and the receiving terminal cannot be met, resulting in reduced data throughput, and even causing loss of communication synchronization. Therefore, the maximum number of iterations is to be matched again, ensure communication performance. The system computing capability information is matched based on the processor model. Regardless of whether the system load increases, if the processor model does not change, the system computing capability information remains unchanged. Therefore, the user terminal reruns the LDPC decoding test case, re-obtains the use case decoding time, and rematches the maximum number of iterations of the LDPC decoding based on the system computing capability information and the re-obtained use case decoding time. The user terminal performs the LDPC iterative decoding based on the rematched maximum number of iterations. It should be noted that since the system load increases, the rematched maximum number of iterations is less than a maximum number of iterations matched in a normal state.

For ease of understanding, the corresponding maximum number of iterations of the LDPC decoding to be rematched is described through examples below based on Table 3.

**Table 3**

| Use case decoding time | System computing capability information | Maximum number of iterations |
|---|---|---|
| < 20 us | > 90 | 25 |
| < 30 us | > 80 | 20 |
| < 40 us | > 70 | 18 |
| < 50 us | > 60 | 15 |
| < 60 us | > 50 | 13 |
| < 70 us | > 40 | 10 |

Based on the matching table of iterations shown in Table 3, when the use case decoding time of the user terminal is 15 us, and the matched system computing capability information is 88, the maximum number N_max1 of iterations matched based on the use case decoding time and the system computing capability information is 20. The LDPC iterative decoding starts to be performed based on the N_max1=20, then the timer is started, and the preset time of the timer is equal to 20 multiplied by the sub-preset time. When the LDPC iterative decoding is not terminated, if it is detected that the timer times out, the LDPC decoding test case is rerun, to obtain a current use case decoding time being 42 us. Based on the use case decoding time being equal to 42 us and the system computing capability information being equal to 88, the rematched maximum number of iterations N_max2 is 15. The LDPC iterative decoding starts to be performed based on the N_max2=15, and then the timer is started. In this case, the preset time of the timer is equal to 15 multiplied by the sub-preset time.

It may be learned that the preset time of the timer is also correspondingly adjusted with the adjustment of the maximum number of iterations, so that the timer can keep accurate time during the next LDPC iterative decoding.

When it is not detected that the timer times out, it indicates that the system load of the processor of the user terminal has not increased significantly, and the speed at which the user terminal performs the LDPC decoding is not affected, and S110 is performed.

S111: Clear the timer when the LDPC iterative decoding is terminated.

When the next LDPC iterative decoding starts, the timer starts timing again.

To prevent the increased system load from causing degraded communication performance, a timer is added to monitor a time consumed by the user terminal to perform the LDPC iterative decoding. When the timer times out, it indicates that the time consumed by the LDPC iterative decoding exceeds the preset time. The LDPC iterative decoding is performed through the current maximum number of iterations. This may lead to degradation in the communication performance. Therefore, the LDPC decoding test case is rerun to obtain the decoding test time. Based on the re-obtained decoding test time and the system computing capability information, the maximum number of iterations is rematched, and the LDPC iterative decoding is performed based on the rematched maximum number of iterations to ensure the communication performance.

An embodiment of this application provides a decoding method for a low-density parity-check code, to obtain a processor model of a user terminal. Corresponding system computing capability information is matched based on the processor model of the user terminal. An LDPC decoding test case is run to obtain a use case decoding time. A corresponding maximum number of iterations is matched based on the matched system computing capability information and the use case decoding time. LDPC iterative decoding is performed based on the matched maximum number of iterations. In this embodiment of this application, the maximum number of iterations is cooperatively matched based on the system computing capability information of the user terminal and the use case decoding time. The LDPC decoding is performed through the maximum number of iterations. This reduces a bit error rate of the LDPC decoding to some extent while meeting a requirement of the communication system for the communication performance, thereby reducing a number of data retransmissions.

Further, according to the decoding method for a low-density parity-check code provided in embodiments of this application, in response to initialization (power-on startup and running of a system program) of the user terminal, the processor model of the user terminal starts to be obtained. The processor model of the user terminal does not need to be obtained each time the LDPC iterative decoding is performed. This reduces repeated waste of computing resources.

Further, the timer is added to monitor the time consumed by the user terminal to perform the LDPC iterative decoding. When the timer times out, the maximum number of iterations is rematched, to prevent the increased system load from causing the degraded communication performance.

The foregoing decoding method for a low-density parity-check code described in the foregoing Embodiment I is implemented through a user terminal, and the following decoding method for a low-density parity-check code described in Embodiment II is implemented through cooperation between the user terminal and a network side device.

### Embodiment II:

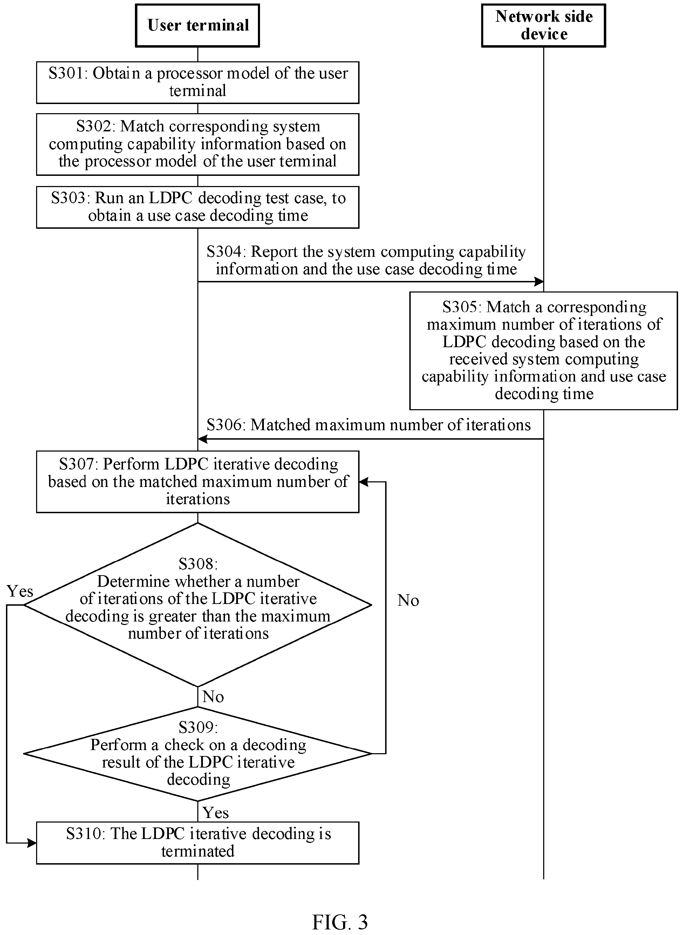

Another decoding method for a low-density parity-check code provided in this embodiment of this application is described in detail below with reference to FIG. 3. The method is implemented through cooperation between a user terminal and a network side device. The method includes the following steps.

S301: The user terminal obtains a processor model of the user terminal.

S302: The user terminal matches corresponding system computing capability information based on the processor model of the user terminal.

S303: The user terminal runs an LDPC decoding test case, to obtain a use case decoding time.

The foregoing S301-S303 are the same as S101-S103 in Embodiment I. For details of specific implementations of S301-S303, reference is made to S101-S103 in Embodiment I, and details are not described herein again.

S304: The user terminal reports system computing capability information and a use case decoding time to the network side device.

The network side device (which may also be referred to as a network device) is a dedicated hardware device for connecting various nodes such as a server, a PC, and a user terminal with each other to form an information communication network. Common network side devices include a switch, a router, a firewall, a network bridge, a hub, a gateway, a VPN server, a network interface card (NIC), a wireless access point (WAP), a modem, a 5G base station, an optical transceiver, a fiber optic transceiver, an optical cable, and the like.

In a possible implementation, the system computing capability information and the use case decoding time are reported to the network side device through ue capability information. The Ue capability information is uplink UE (user terminal) capability query response information.

In another possible implementation, the use case decoding time and the system computing capability information are reported to the network side device through an NAS signaling Registration Request carried in RRC SetupComplete. The RRC SetupComplete is a response, received by the user terminal, to an "RRC SETUP" message indicating that a radio resource is allocated to the network side device. The Registration Request is a registration request message frequently used by the user terminal.

S305: The network side device matches the corresponding maximum number of iterations of the LDPC decoding based on the received system computing capability information and the use case decoding time.

In a possible implementation, the network side device matches the corresponding maximum number of iterations of the LDPC decoding based on a preset matching table of iterations and the received system computing capability information and use case decoding time. In another possible implementation, the network side device may match the corresponding maximum number of iterations of the LDPC decoding based on the received system computing capability information and use case decoding time in another manner such as a preset formula or a machine learning model. This is not specifically limited in this application.

The system computing capability information and the use case decoding time are sent to the network side device, and the network side device matches the corresponding maximum number of iterations of the LDPC decoding and sends the maximum number of iterations to the user terminal, thereby reducing resource consumption of the user terminal.

S306: The network side device sends the matched maximum number of iterations to the user terminal.

In a possible implementation, the network device sends the matched maximum number of iterations to a user through DCI information.

The DCI information (Downlink Control Information, downlink control information) is formed in a predetermined format, and the network side device unicasts the downlink control information to each user terminal in a PDCCH. A DCI format provides the user terminal with details such as a number of resource blocks, a resource allocation type, a modulation scheme, a transmission block, a redundancy version, and a code rate. In this embodiment of this application, the DCI information carries the matched maximum number of iterations to the user terminal.

S307: The user terminal performs LDPC iterative decoding based on the received maximum number of iterations.

S308: The user terminal determines whether a number of iterations of the LDPC iterative decoding is greater than the maximum number of iterations.

When the number of iterations of the LDPC iterative decoding is not greater than the maximum number of iterations, S309 is performed.

When the number of iterations of the LDPC iterative decoding is greater than the maximum number of iterations, S310 is performed.

S309: The user terminal performs a check on a decoding result of the LDPC iterative decoding.

When the decoding result of the LDPC iterative decoding passes the check, S310 is performed.

When the decoding result of the LDPC iterative decoding does not pass the check, S307 is performed, that is, the LDPC iterative decoding continues to be performed, and then it is determined whether the number of iterations of the LDPC iterative decoding is greater than the maximum number of iterations and whether the decoding result passes the check. The LDPC iterative decoding is terminated until the number of iterations of the LDPC iterative decoding is greater than the maximum number of iterations (reaching the maximum number of iterations) or the decoding result of the LDPC iterative decoding passes the check.

S310: The LDPC iterative decoding is terminated.

A corresponding LDPC decoding result is outputted after the end of the LDPC iterative decoding.

It should be noted that the user terminal performs timing through a timer when performing S305-S308.

During the LDPC iterative decoding, if it is detected that the timer times out, the LDPC decoding test case is rerun to obtain the use case decoding time. The processor model and the re-obtained use case decoding time are sent to the network side device. The network side device rematches the corresponding maximum number of iterations based on the processor model and the re-obtained use case decoding time, and sends the maximum number of iterations to the user terminal. In this way, the user terminal performs the LDPC iterative decoding based on the rematched maximum number of iterations.

According to the decoding method for a low-density parity-check code provided in embodiments of this application, the user terminal sends the system computing capability information and the use case decoding time to the network side device. The network side device matches the corresponding maximum number of iterations, and returns the maximum number of iterations to the user terminal, and the user terminal performs the LDPC decoding based on the maximum number of iterations matched by the network side device. To be specific, the network side device cooperatively matches the maximum number of iterations based on the system computing capability information of the user and the use case decoding time, and returns the matched maximum number of iterations to the user terminal. The user terminal performs the LDPC decoding through the maximum number of iterations. This reduces a bit error rate of the LDPC decoding to some extent while meeting a requirement of the communication system for the communication performance, thereby reducing a number of data retransmissions.

Further, the system computing capability information of the user terminal and the use case decoding time are sent to the network side device, and the network side device matches the corresponding maximum number of iterations based on the system computing capability information and the use case decoding time, thereby reducing occupation of computing resources of the user equipment.

It may be learned from Embodiment I and Embodiment II that the maximum number of iterations of the LDPC decoding of the user terminal may be matched through cooperative matching by the user terminal based on the system computing capability information and the use case decoding time, or may be matched through cooperative matching by the network side device based on the system computing capability information of the user terminal and the use case decoding time, and is returned to the user terminal. Therefore, for the decoding method for a low-density parity-check code provided in this application, a manner of matching the maximum number of iterations may be selected based on an actual situation. This is not specifically limited in this application. For ease of description, the manner of matching the maximum number of iterations of the LDPC decoding in the following embodiment is merely an example of the manner of cooperatively matching by the user terminal based on the system computing capability information and the use case decoding time.

The foregoing decoding method for a low-density parity-check code described in the foregoing Embodiment II is implemented through cooperation between the user terminal and the network side device. The following decoding method for a low-density parity-check code described in Embodiment III is cooperatively implemented by a plurality of user terminals.

### Embodiment III:

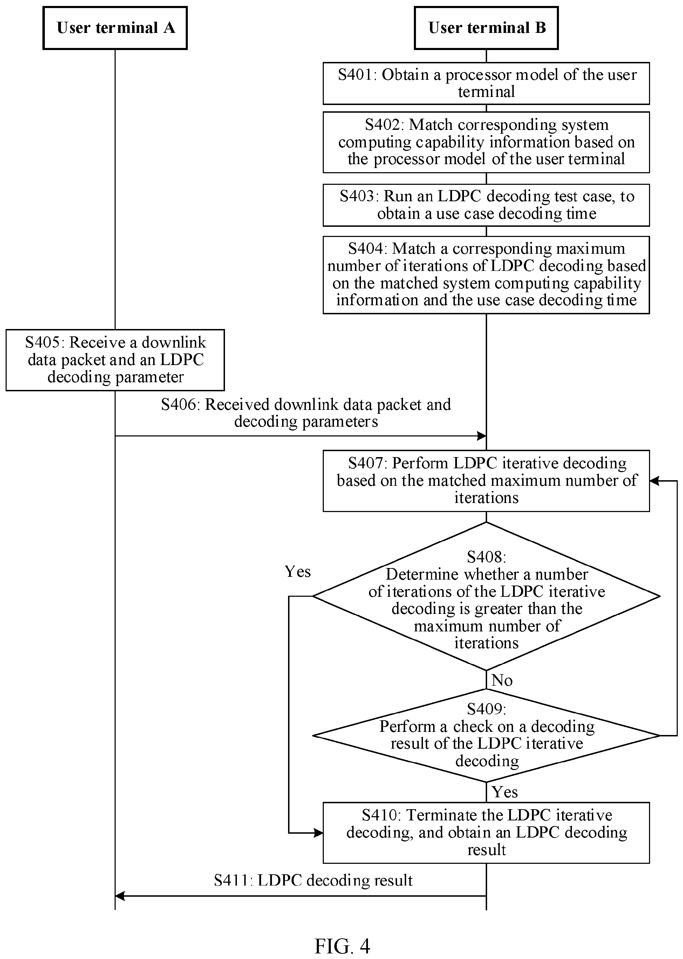

Another decoding method for a low-density parity-check code provided in this embodiment of this application is described in detail below with reference to FIG. 4. The method is applicable to a cooperative decoding scenario, that is, the decoding method for a low-density parity-check code provided in this embodiment of this application is cooperatively completed by a plurality of user terminals.

Cooperative decoding refers to coordinating two or more different user terminals to cooperatively and unanimously complete a task of LDPC decoding.

For ease of understanding, two different user terminals (which are respectively a user terminal A and a user terminal B) are used as an example for detailed description. A computing capability of the user terminal A is relatively weak, and a computing capability of the user terminal B is relatively strong. The method includes the following steps.

S401: The user terminal B obtains a processor model of the user terminal B.

S402: The user terminal B matches corresponding system computing capability information based on the processor model of the user terminal B.

S403: The user terminal B runs an LDPC decoding test case, to obtain a use case decoding time.

S404: The user terminal B matches the corresponding maximum number of iterations of the LDPC decoding based on the matched system computing capability information and the use case decoding time.

S405: The user terminal A receives a downlink data packet and an LDPC decoding parameter.

The LDPC decoding parameter includes an LDPC coding manner, a code length, a code rate, or the like.

S406: The user terminal A sends the received downlink data packet and a decoding parameter to the user terminal B.

S407: The user terminal B performs LDPC iterative decoding based on the matched maximum number of iterations.

The user terminal B performs, based on the matched maximum number of iterations, the LDPC iterative decoding on the downlink data packet sent by the user terminal A.

S408: The user terminal B determines whether a number of iterations of the LDPC iterative decoding is greater than the maximum number of iterations.

When the number of iterations of the LDPC iterative decoding is not greater than the maximum number of iterations, S407 is performed.

When the number of iterations of the LDPC iterative decoding is greater than the maximum number of iterations, the LDPC iterative decoding is terminated, and S710 is performed.

S409: The user terminal B performs a check on a decoding result of the LDPC iterative decoding.

When the decoding result of the LDPC iterative decoding passes the check, the LDPC iterative decoding is terminated, and S410 is performed.

When the decoding result of the LDPC iterative decoding does not pass the check, S407 is performed.

S410: The user terminal B terminates the LDPC iterative decoding, and obtains an LDPC decoding result.

S411: The user terminal B feeds back the LDPC decoding result to the user terminal A.

In this case, the user terminal A receives the LDPC decoding result fed back by the user terminal B, to complete this cooperative decoding.

It should be noted that while the user terminal A and the user terminal B cooperatively complete the LDPC decoding, the user terminal B may still perform, based on the matched maximum number of iterations, the LDPC iterative decoding on the downlink data packet received by the user terminal B. FIG. 4 only shows the process in which the user terminal A and the user terminal B cooperatively perform decoding.

It may be learned from FIG. 4 that in the cooperative decoding scenario, when the user terminal A receives the to-be-decoded data packet, the user terminal A does not perform the LDPC iterative decoding, but sends the data packet to the user terminal B. The user terminal B performs the LDPC iterative decoding on the data packet sent by the user terminal A, to obtain and feed back the LDPC decoding result to the user terminal A, thereby completing the LDPC decoding on the data packet received by the user terminal A, that is, completing this cooperative decoding. To be specific, the user terminal A does not need to perform the LDPC iterative decoding. Therefore, in the cooperative decoding scenario, the user terminal B can match the corresponding maximum number of iterations based on the system computing capability information thereof and the use case decoding time.

### Embodiment IV:

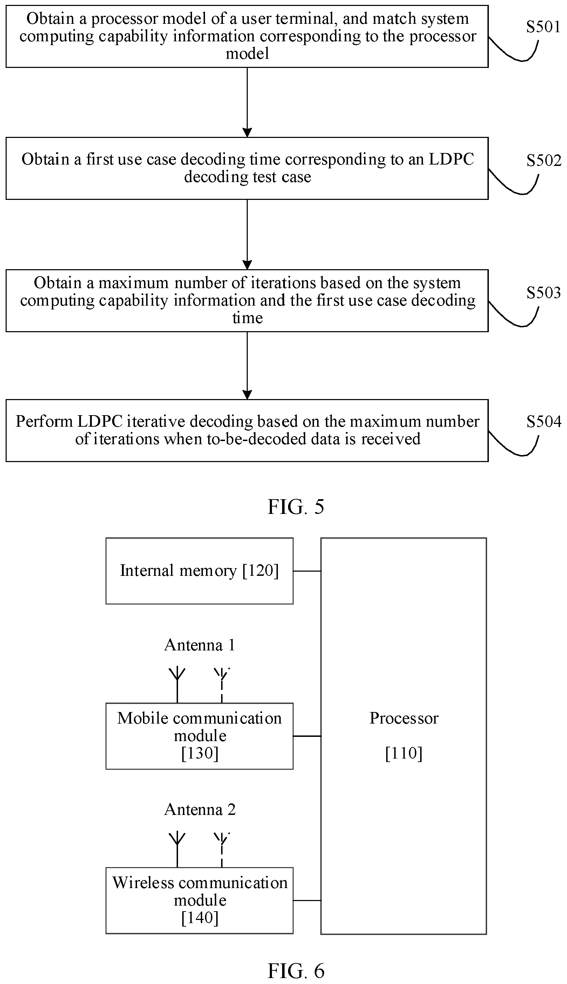

Another decoding method for a low-density parity-check code provided in this embodiment of this application is described in detail below with reference to FIG. 5.

S501: Obtain a processor model of a user terminal, and match system computing capability information corresponding to the processor model.

Specifically, the processor model of the user terminal is obtained in response to an initialization operation of the user terminal.

S502: Obtain a first use case decoding time corresponding to an LDPC decoding test case.

Specifically, the LDPC decoding test case is run to obtain the first use case decoding time.

In a possible implementation, when a plurality of LDPC decoding test cases are provided, the plurality of LDPC decoding test cases are run, to obtain a plurality of decoding times respectively corresponding to the plurality of LDPC decoding test cases. The first use case decoding time corresponding to each of the LDPC decoding test cases is obtained based on the plurality of decoding times.

S503: Obtain a maximum number of iterations based on the system computing capability information and the first use case decoding time.

Specifically, the maximum number of iterations corresponding to the system computing capability information and the first use case decoding time is obtained based on a matching table of iterations.

In a possible implementation, a first number of iterations corresponding to the system computing capability information is matched based on the matching table of iterations, a second number of iterations corresponding to the decoding time is matched based on the matching table of iterations, and the maximum number of iterations corresponding to the system computing capability information and the first use case decoding time is determined based on the first number of iterations and the second number of iterations.

In a possible implementation, a set of maximum numbers of iterations corresponding to the system computing capability information is screened out from the matching table of iterations. The maximum number of iterations corresponding to the decoding time is screened out from the set of maximum numbers of iterations, or the set of maximum numbers of iterations corresponding to the first use case decoding time is screened out from the matching table of iterations. The maximum number of iterations corresponding to the system computing capability information is screened out from the set of maximum numbers of iterations.

In a possible implementation, the system computing capability information and the first use case decoding time are sent to a network side device, so that the network side device determines the maximum number of iterations based on the system computing capability information and the first use case decoding time, and returns the maximum number of iterations. This reduces occupation of computing resources of the user equipment.

S504: Perform LDPC iterative decoding based on the maximum number of iterations when to-be-decoded data is received.

Specifically, when the to-be-decoded data is received, the LDPC iterative decoding starts to be performed based on the maximum number of iterations. When the number of iterations reaches the maximum number of iterations, or a decoding result of the LDPC iterative decoding passes a check, the LDPC iterative decoding is terminated.

In a possible implementation, when the LDPC iterative decoding starts to be performed, a timer starts timing. A detection as to whether the timer times out is performed during the LDPC iterative decoding.

When the timer times out, the maximum number of iterations is adjusted, and the LDPC iterative decoding is performed based on the adjusted maximum iterative decoding. Specifically, when the timer times out, a second use case decoding time corresponding to the LDPC decoding test case is obtained, that is, the LDPC decoding test case is rerun to obtain a second use case decoding time. The maximum number of iterations is re-obtained based on the system computing capability information and the second use case decoding time. The maximum number of iterations of LDPC decoding is adjusted to the re-obtained maximum number of iterations.

When the timer has not timed out and the LDPC iterative decoding is terminated, the timer is cleared.

In a possible implementation, the method is applied to a first user terminal. The to-be-decoded data is received by a second user terminal and forwarded to the first user terminal. The first user terminal performs the LDPC iterative decoding on the to-be-decoded data based on the maximum iterative decoding, to obtain a decoding result of the LDPC iterative decoding, and returns the decoding result of the LDPC iterative decoding to the second user terminal. The system computing capability of the first user terminal is higher than the system computing capability of the second user terminal. The cooperative decoding between the first user terminal and the second user terminal is implemented.

An embodiment of this application provides a decoding method for a low-density parity-check code. A processor model of a user terminal is obtained, and system computing capability information corresponding to the processor model is matched. A first use case decoding time corresponding to a low-density parity-check LDPC decoding test case is obtained. A maximum number of iterations is obtained based on the system computing capability information and the first use case decoding time. LDPC iterative decoding is performed based on the maximum number of iterations when to-be-decoded data is received. For the system computing capability information, higher system computing capability information of a user terminal indicates a faster speed for performing one iteration of LDPC decoding. On the premise of ensuring communication performance, the user terminal having higher system computing capability information can match a larger maximum number of iterations. For a use case decoding time, a shorter use case decoding time indicates a faster LDPC decoding speed. On the premise of meeting a requirement of the communication system for communication performance, a user terminal spending a shorter use case decoding time can match a larger maximum number of iterations. With reference to two aspects including the system computing capability information and the first use case decoding time, the maximum number of iterations is cooperatively matched, thereby reducing the bit error rate of the LDPC decoding to some extent when the user terminal meets the requirement for communication performance, and reducing the number of data retransmissions.

This embodiment provides an electronic device. The electronic device may also be referred to as a user terminal. The electronic device includes a processor and a memory. The memory stores computer-executable instructions. The processor executes the computer-executable instructions stored in the memory, to enable the processor to perform the relevant method steps in FIG. 1 to FIG. 5.

For ease of understanding, the user terminal is described in detail below with reference to FIG. 6.

As shown in FIG. 1, the electronic device may include a processor 110, an internal memory 120, an antenna 1, an antenna 2, a mobile communication module 130, a wireless communication module 140, and the like.

The processor 110 may include one or more processing units. For example, the processor 110 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, and/or a neural-network processing unit (neural-network processing unit, NPU).

The controller may be a nerve center and a command center of the electronic device. The controller may generate an operation control signal based on an instruction operation code and a timing signal, to complete control of instruction fetching and execution.

A memory may further be arranged in the processor 110, and is configured to store instructions and data. In some embodiments, the memory in the processor 110 is a cache memory. The memory may store the instructions or data that has just been used or recycled by the processor 110. If the processor 110 needs to use the instructions or the data again, the processor may directly invoke the instructions or the data from the memory. This avoids repeated access, and reduces a waiting time of the processor 110, thereby improving system efficiency.

In this application, the modem processor may implement functions of a convolutional encoder/decoder, a tail-biting (tail-biting) convolution encoder/decoder, a turbo, a Viterbi (Viterbi) encoder/decoder, and/or a low-density parity-check (LDPC) encoder/decoder. An LDPC iterative decoding function provided in this application is implemented based on the modem processor.

A wireless communication function of the electronic device may be implemented through the antenna 1, the antenna 2, the mobile communication module 130, the wireless communication module 140, the modem processor, the baseband processor, and the like.

The mobile communication module 130 may provide a solution to wireless communication including 2G/3G/4G/5G and the like applied to the electronic device.

The wireless communication module 140 may provide a solution to wireless communication including a wireless local area network (wireless local area networks, WLAN) (for example, a wireless fidelity (wireless fidelity, Wi-Fi) network), Bluetooth (bluetooth, BT), a global navigation satellite system (global navigation satellite system, GNSS), frequency modulation (frequency modulation, FM), near field communication (near field communication, NFC), an infrared (infrared, IR) technology, and the like applied to the electronic device.

In some embodiments, in the electronic device, the antenna 1 is coupled to the mobile communication module 130, and the antenna 2 is coupled to the wireless communication module 140, so that the electronic device can communicate with a network and another device through a wireless communication technology.

Embodiments further provide a computer-readable storage medium. The computer-readable storage medium includes instructions. When the instructions are run on an electronic device, the electronic device is enabled to perform the steps of related methods in FIG. 1 to FIG. 5, to implement the methods in the foregoing embodiments.

Embodiments further provide a computer program product including instructions. When the computer program product is run on an electronic device, the electronic device is enabled to perform the steps of related methods in FIG. 1 to FIG. 5, to implement the methods in the foregoing embodiments.

## Claims

1. A decoding method for a low-density parity-check code, comprising:
obtaining a processor model of a user terminal, and matching system computing capability information corresponding to the processor model;
obtaining a first use case decoding time corresponding to a low-density parity-check LDPC decoding test case;
obtaining a maximum number of iterations based on the system computing capability information and the first use case decoding time; and
performing LDPC iterative decoding based on the maximum number of iterations when to-be-decoded data is received.

2. The method according to claim 1, wherein a plurality of LDPC decoding test cases are provided; and
the obtaining a first use case decoding time corresponding to a low-density parity-check LDPC decoding test case comprises:
obtaining a plurality of decoding times respectively corresponding to the plurality of LDPC decoding test cases; and
obtaining the first use case decoding time corresponding to the LDPC decoding test case based on the plurality of decoding times.

3. The method according to claim 1, wherein the obtaining a maximum number of iterations based on the system computing capability information and the first use case decoding time comprises:
obtaining the maximum number of iterations corresponding to the system computing capability information and the first use case decoding time based on a matching table of iterations.

4. The method according to claim 3, wherein the obtaining the maximum number of iterations corresponding to the system computing capability information and the first use case decoding time based on a matching table of iterations comprises:
matching a first number of iterations corresponding to the system computing capability information based on the matching table of iterations;
matching a second number of iterations corresponding to the first use case decoding time based on the matching table of iterations; and
determining the maximum number of iterations corresponding to the system computing capability information and the first use case decoding time based on the first number of iterations and the second number of iterations.

5. The method according to claim 3, wherein the obtaining the maximum number of iterations corresponding to the system computing capability information and the first use case decoding time based on a matching table of iterations comprises:
screening out a set of maximum numbers of iterations corresponding to the system computing capability information from the matching table of iterations, and screening out the maximum number of iterations corresponding to the first use case decoding time from the set of maximum numbers of iterations;
or
screening out a set of maximum numbers of iterations corresponding to the first use case decoding time from the matching table of iterations, and screening out the maximum number of iterations corresponding to the system computing capability information from the set of maximum numbers of iterations.

6. The method according to claim 1, wherein the obtaining a maximum number of iterations based on the system computing capability information and the first use case decoding time comprises:
sending the system computing capability information and the first use case decoding time to a network side device, so that the network side device determines the maximum number of iterations based on the system computing capability information and the first use case decoding time, and returns the maximum number of iterations.

7. The method according to claim 1, wherein the performing LDPC iterative decoding based on the maximum number of iterations when to-be-decoded data is received comprises:
starting to perform the LDPC iterative decoding based on the maximum number of iterations when the to-be-decoded data is received; and
ending the LDPC iterative decoding when a number of iterations reaches the maximum number of iterations or a decoding result of the LDPC iterative decoding passes a check.

8. The method according to claim 7, further comprising:
starting, by a timer, timing when the LDPC iterative decoding starts to be performed;
detecting whether the timer times out during the LDPC iterative decoding; and
adjusting the maximum number of iterations when the timer times out, and performing the LDPC iterative decoding based on the adjusted maximum iterative decoding.

9. The method according to claim 8, wherein the adjusting the corresponding maximum number of iterations comprises:
obtaining a second use case decoding time corresponding to the LDPC decoding test case, wherein the second use case decoding time is greater than the first use case decoding time;
re-obtaining a maximum number of iterations based on the system computing capability information and the second use case decoding time; and
adjusting the maximum number of iterations to the re-obtained maximum number of iterations.

10. The method according to claim 8, further comprising:
clearing the timer when the timer has not timed out and the LDPC iterative decoding is terminated.

11. The method according to claim 1, wherein the method is applied to a first user terminal, the to-be-decoded data is received by a second user terminal and forwarded to the first user terminal, and after the performing LDPC iterative decoding based on the maximum number of iterations, the method further comprises:
returning, by the first user terminal, a decoding result of the LDPC iterative decoding to the second user terminal, wherein system computing capability of the first user terminal is higher than system computing capability of the second user terminal.

12. The method according to any one of claims 1 to 11, wherein the obtaining a processor model of a user terminal comprises:
obtaining the processor model of the user terminal in response to an initialization operation of the user terminal.

13. An electronic device, comprising a processor and a memory, wherein
the memory stores computer-executable instructions; and
the processor executes the computer-executable instructions stored in the memory, to enable the processor to perform the method according to any one of claims 1 to 12.

14. A computer-readable storage medium, storing a computer program or instructions, wherein the computer program or the instructions, when run, implement the method according to any one of claims 1 to 12.
